# EUROPEAN PATENT APPLICATION

(11) **EP 4 807 995 A1**
(43) Date of publication of application: **16.09.2026**
(21) Application number: 25194390.8
(22) Date of filing: 06.08.2025
(51) Int. Cl.: H03M 7/30, G06F 7/544, G06F 17/16

(54) **METHOD FOR ACCELERATING GENERAL MATRIX MULTIPLY FOR QUANTIZATION MODEL BASED ON CODEBOOK, AND COMPUTING DEVICE THEREFOR**

(30) Priority: 14.03.2025 KR 20250033575; 02.04.2025 KR 20250043006
(71) Applicant: NAVER Cloud Corp., Seongnam-si, Gyeonggi-do 13561 (KR)
(72) Inventor: PARK, Gunho, 13529 Seongnam-si (KR); BAE, Jeongin, 13529 Seongnam-si (KR); KIM, Byeoung Wook, 13529 Seongnam-si (KR); PARK, Baeseong, 13529 Seongnam-si (KR); RYU, Jiwon, 13529 Seongnam-si (KR); KIM, Hoseung, 13529 Seongnam-si (KR); KWON, Se Jung, 13529 Seongnam-si (KR); LEE, Dongsoo, 13529 Seongnam-si (KR)
(74) Representative: HGF

(57) **Abstract**

A method for accelerating general matrix multiply (GEMM) for a quantization model based on a codebook, includes generating at least one input segment by reshaping an input activation vector, generating a partial sum book (Psum book) including partial sums corresponding to respective codes in the codebook of the quantization model by performing a matrix operation between the codebook and the at least one input segment, retrieving the partial sums corresponding to the respective codes included in a code matrix of the quantization model by referring to the partial sum book, and generating an output vector corresponding to the input activation vector by using the retrieved partial sums.

## Description

### CROSS REFERENCE TO RELATED APPLICATIONS

The present application claims priority to Korean Patent Application No. 10-2025-0033575, filed March 14, 2025, and Korean Patent Application No. 10-2025-0043006, filed April 02, 2025, the entire contents of which are incorporated herein.

### BACKGROUND OF THE INVENTION

### Field of the Invention

The present invention relates to an acceleration method for performing general matrix multiply in a quantization model based on a codebook, and a computing device therefor.

### Description of the Related Art

Generative language models have gained significant attention in fields such as natural language understanding, natural language generation, and inference. However, generative language models are generally large in scale, leading to many problems in applying generative language models to services. However, even practical generative language models have billions of weights, resulting in burdens related to cost, resources, and call time when the models are provided to users. Therefore, for economical services, extensive research has been conducted to compress practical generative language models.

In general, quantization methods may be implemented on the basis of uniform quantization, in which representational intervals are kept constant. In this case, it is easy to represent quantization values, and it is relatively straightforward to implement kernels and operators that support quantization. For uniform quantization techniques, less degradation of accuracy compared to an original model may be achieved in 4-bit or 3-bit quantization environments.

However, in extreme low-bit quantization of 2 bits or fewer, the performance of quantization models degrades significantly due to limitations of uniform quantization. For example, in 2-bit quantization, a total of four values are used to represent original real-number data. Herein, when values are arranged at uniform intervals, the representational limitations may result in large quantization errors. To address this, non-uniform quantization techniques have been proposed, and among these, codebook-based quantization techniques have been used.

The foregoing is intended merely to aid in the understanding of the background of the present disclosure, and is not intended to mean that the present invention falls within the purview of the related art that is already known to those skilled in the art.

### SUMMARY OF THE INVENTION

The present invention is defined by the independent claims. Further aspects of the present invention are outlined in the dependent claims. The present invention is directed to providing a method for accelerating general matrix multiply for a quantization model based on a codebook, and a computing device therefor, the method and the computing device being capable of minimizing codebook-related overhead occurring in an operation process of the quantization model based on the codebook.

The present invention is directed to providing a method for accelerating general matrix multiply for a quantization model based on a codebook, and a computing device therefor, the method and the computing device being capable of optimizing operation performance by removing unnecessary operations occurring in an operation process of the quantization model based on the codebook.

According to an example of the present disclosure, there is provided a method for accelerating general matrix multiply (GEMM) for a quantization model based on a codebook, the method being performed by a processor and including: generating at least one input segment by reshaping an input activation vector; generating a partial sum book (Psum book) including partial sums corresponding to respective codes in the codebook of the quantization model by performing a matrix operation between the codebook and the at least one input segment; retrieving the partial sums corresponding to the respective codes included in a code matrix of the quantization model by referring to the partial sum book; and generating an output vector corresponding to the input activation vector by using the retrieved partial sums.

According to an example of the present disclosure, there is provided a computing device for accelerating general matrix multiply (GEMM) for a quantization model based on a codebook, the computing device including a processor, wherein the processor is configured to: generate at least one input segment by reshaping an input activation vector; generate a partial sum book (Psum book) including partial sums corresponding to respective codes in the codebook of the quantization model by performing a matrix operation between the codebook and the at least one input segment; retrieve the partial sums corresponding to the respective codes included in a code matrix of the quantization model by referring to the partial sum book; and generate an output vector corresponding to the input activation vector by using the retrieved partial sums.

Furthermore, the above-described technical solutions to the technical problems are not all of the features of the present invention. Various features of the present invention and advantages and effects thereof will be more fully understood with reference to the following detailed examples.

According to a method for accelerating general matrix multiply for a quantization model based on a codebook and a computing device therefor according to an example of the present disclosure, instead of storing the entire codebook in a cache, a partial sum corresponding to the result of the operation is stored, thereby reducing the memory space complexity. In addition, overhead that may be incurred in the process of loading the codebook into the cache can be avoided.

According to a method for accelerating general matrix multiply for a quantization model based on a codebook and a computing device therefor according to an example of the present disclosure, since a partial sum book including a result of pre-operation is referred to, unnecessary operations are removed and operation complexity is reduced.

However, the effects that can be achieved by a method for accelerating general matrix multiply for a quantization model based on a codebook and a computing device therefor according to examples of the present disclosure are not limited to those mentioned above, and other effects not mentioned will be apparent to those skilled in the art from the following description.

### BRIEF DESCRIPTION OF THE DRAWINGS

The above and other objectives, features, and other advantages of the present invention will be more clearly understood from the following detailed description when taken in conjunction with the accompanying drawings, in which:
FIG. 1 is a diagram illustrating an example of generating a code matrix and a codebook of a quantization model based on a codebook;
FIG. 2 is a diagram illustrating an example of dequantization and a matrix operation of a quantization model based on a codebook;
FIG. 3 is a diagram illustrating an example of a real-time dequantization-based matrix operation of a quantization model based on a codebook;
FIG. 4 is a schematic diagram illustrating the operation of a matrix operation kernel of a quantization model based on a codebook according to an example of the present disclosure;
FIG. 5 is a schematic diagram illustrating the operation of a matrix operation kernel of a quantization model based on a codebook;
FIG. 6 is a diagram illustrating an example of generating a partial sum book in a quantization model based on a codebook and generating an output vector by using the partial sum book according to an example of the present disclosure;
FIG. 7 is a diagram illustrating an example of reshaping an input activation vector according to an example of the present disclosure;
FIG. 8 is a diagram illustrating an example of generating partial sum books by using a codebook and input segments according to an example of the present disclosure;
FIG. 9 is a diagram illustrating an example of generating an output vector by using a code matrix and partial sum books according to an example of the present disclosure;
FIG. 10 is a block diagram illustrating a computing environment suitable for use in examples of the present disclosure; and
FIG. 11 is a flowchart illustrating a method for accelerating general matrix multiply for a quantization model based on a codebook according to an example of the present disclosure.

### DETAILED DESCRIPTION OF THE INVENTION

Hereinafter, example of the present disclosure in the present specification will be described in detail with reference to the accompanying drawings. Throughout the drawings, like or similar elements are denoted by the same reference numerals, and a redundant description thereof will be omitted.

In addition, the accompanying drawings are only for easy understanding of the example disclosed in the present specification, and do not limit the technical features disclosed in the present specification. It is to be understood that the present invention includes all modifications, and substitutions included in the scope of the present invention.

A generative language model performs natural language processing (NLP) and may generate a new sentence corresponding to an input sentence to provide the new sentence as an output sentence. In general, generative language models may be used in various fields, such as text generation in speech-to-text (STT), translation, chatbots, document summarization, and query answering.

A generative language model may be implemented as a probability model that predicts the next token based on a sequence of input tokens corresponding to an input sentence, and may generate an output sentence by learning a sequence of tokens included in a sentence through training data, calculating the conditional probability of the next token, and selecting the most probable token.

Herein, a generative language model may be implemented using a recurrent neural network (RNN), long short-term memory (LSTM), a gated recurrent unit (GRU), and a transformer. Recently, it has become common to implement generative language models using transformers. Examples of generative language models include a generative pre-trained transformer (GPT), bidirectional encoder representations from transformers (BERT), and Text-To-Text Transfer Transformer (T5).

Generative language models are generally very large in scale and therefore require substantial hardware and energy resources during training or inference, and present challenges in terms of deployment and maintenance. Accordingly, in order to enable economical and efficient services, it is necessary to compress generative language models, and a method has been proposed in which model compression is achieved by applying quantization to the weights of the generative language models.

In quantization techniques, the input may remain a floating-point (FP) format, and the weights of the model may be represented in integer formats of 4 bits or fewer, thereby reducing memory usage. In general, quantization techniques may be implemented on the basis of uniform quantization, in which representational intervals are kept constant. In this case, it is easy to represent quantization values, and it is relatively straightforward to implement kernels and operators that support quantization. For uniform quantization techniques, less degradation of accuracy compared to an original model may be achieved in quantization environments, such as 4-bit and 3-bit.

However, in extreme low-bit quantization of 2 bits or fewer, the performance of quantization models degrades significantly due to limitations of uniform quantization. For example, in 2-bit quantization, a total of four values are used to represent original real-number data. Herein, when values are arranged at uniform intervals, the representational limitations may result in large quantization errors. To address this, non-uniform quantization techniques have been proposed, and among these, codebook-based quantization techniques have been used.

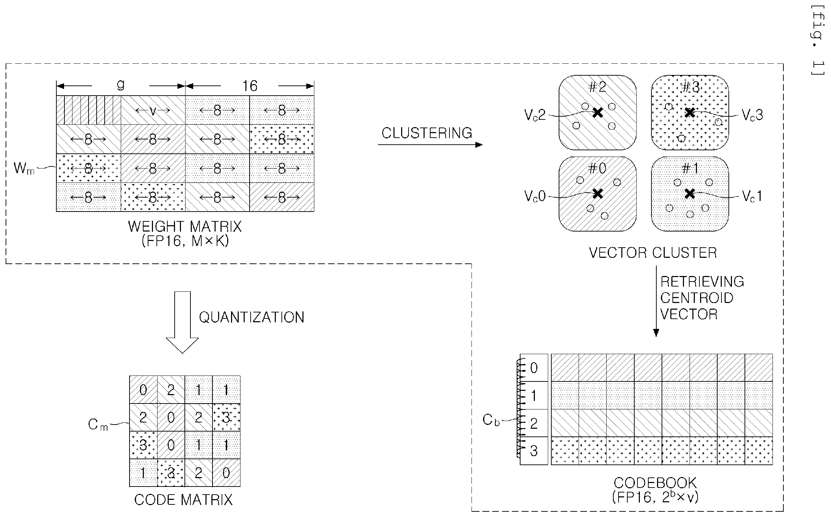

Referring to FIG. 1, for codebook-based quantization, an entire weight matrix (Wm) may be divided into vectors of length v. Each of the vectors may include v weights. In some examples, the vectors may be normalized by group for effective clustering of the vectors. Herein, FIG. 1 shows the case in which the length (v) of a vector is 8 and a group size (g) is 16. In this case, one group includes 16 weights, and two vectors may be included in one group. That is, normalization may be performed on two vectors for each group. Herein, the group size (g) may have a value always equal to or greater than the length (v) of a vector. The length (v) of a vector and the group size (g) may be set as respective hyperparameters.

The vectors are clustered to generate a plurality of vector clusters (#0, #1, #2, and #3). Herein, various clustering techniques, such as k-means clustering, may be used to generate the vector clusters. Herein, the number of bits per code preset as a hyperparameter may determine the number of clusters. That is, when the number of bits per code is b, 2^{b} vector clusters may be generated, and 0 to 2^{b}-1 code may be allocated to each vector cluster.

When the vector clusters (#0, #1, #2, and #3) are generated, centroid vectors (V_{c}0, V_{c}1, V_{c}2, and V_{c}3) corresponding to the centroids of the respective vector clusters may be obtained. Herein, the centroid vectors (V_{c}0, V_{c}1, V_{c}2, and V_{c}3) serve as representative values for the respective vector clusters, and all vectors included in the same vector cluster may be approximated by the centroid vector. The centroid vectors (V_{c}0, V_{c}1, V_{c}2, and V_{c}3) may be matched to the codes (0, 1, 2, 3) of the respective vector clusters to generate a codebook (Cb).

In addition, the weight matrix (Wm) is expressed by the codes of the vector clusters and may thus be converted into a quantized code matrix (Cm). Through this, higher performance may be maintained even in a 2-bit quantization environment compared to conventional uniform quantization.

Herein, in order to perform matrix operations based on a quantization model based on a codebook, a specialized kernel different from conventional kernels may be required. That is, unlike uniform quantization operations, in the case of a quantization model based on a codebook, it is necessary to refer to a codebook and dequantize the vectors corresponding to each code, and thus a general matrix multiply (GEMM) kernel capable of efficiently processing this may be required.

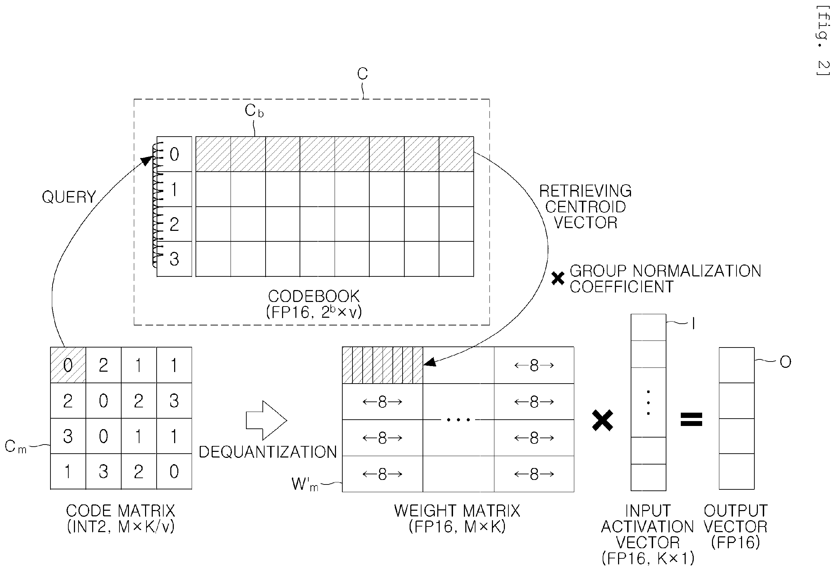

In the related art, as shown in FIG. 2, dequantization is performed by querying a codebook (Cb) with each code included in a code matrix (Cm) and retrieving a centroid vector corresponding to the code from the codebook (Cb). In this case, a weight matrix (W'm) approximated by centroid vectors may be reconstructed, and an output vector (O) corresponding thereby may be generated by performing a matrix multiplication of the weight matrix (W'm) and an input activation vector (I).

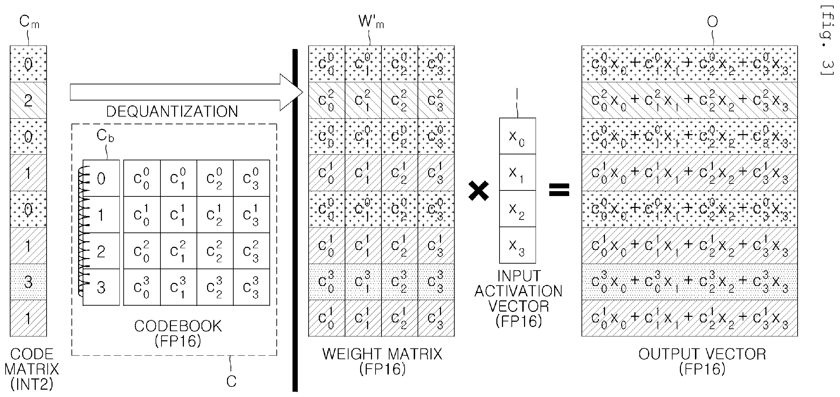

However, as shown in FIG. 3, in order to perform dequantization, a codebook (Cb) is loaded into a cache (C) for processing, and in this case, overhead may occur in loading the codebook (Cb) into the cache (C). Although the size of the codebook (Cb) is relatively small compared to the weight matrix (Wm), the size of the codebook (Cb) also increases as the size of the weight matrix (Wm) increases, and thus there may be cases in which the codebook (Cb) exceeds the capacity of the cache (C). That is, since the entire codebook (Cb) needs to be loaded into the cache (C) for dequantization, problems such as unnecessary memory overhead may occur.

In addition, when a matrix operation between the reconstructed weight matrix (W'm) and the input activation vector (I) is performed, as shown in FIG. 3, the operation between the same centroid vector and the input activation vector (I) may be repeated. That is, since a zeroth vector (V_{c}0) including weights C⁰₀ to C⁰₃ and a first vector (V_{c}1) including weights C¹₀ to C¹₃ are each repeatedly operated three times with the input activation vector (I), it can be seen that inefficiency occurs due to redundant execution of the same operation.

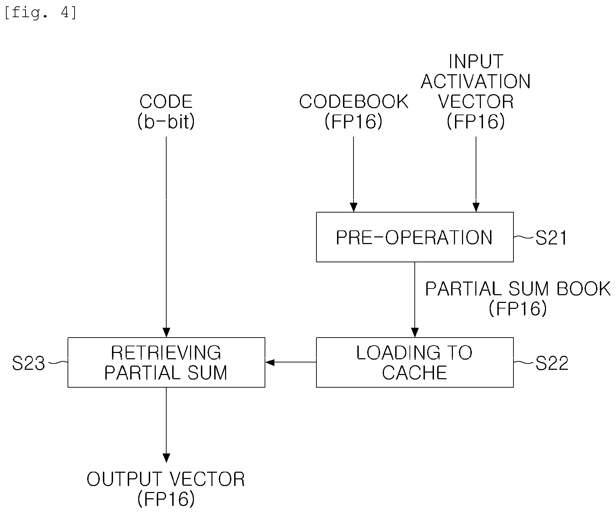

According to a computing device according to an example of the present disclosure, a processor executes a new GEMM kernel to load, in place of a codebook, a partial sum book (Psum book) generated through a pre-operation between the codebook and the input activation vector into a cache. In this case, memory overhead for storing the entire codebook in the cache may be avoided, and redundant execution of the same operation may also be prevented, thereby enabling efficient operation. Hereinafter, the operation of the computing device according to an example of the present disclosure will be described with reference to FIG. 4.

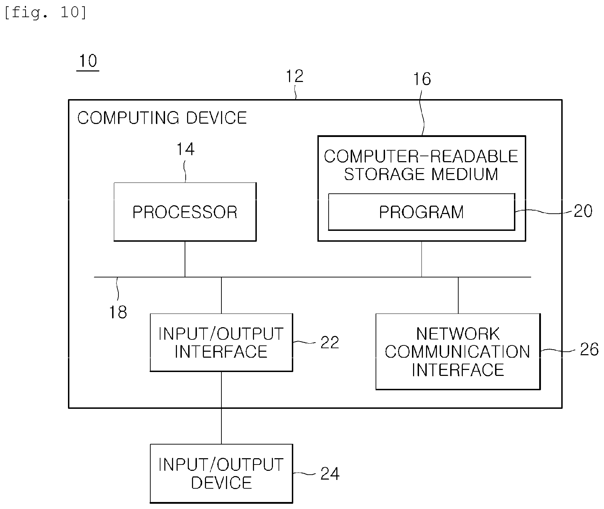

FIG. 4 is a schematic diagram illustrating the operation of a matrix operation kernel of a quantization model based on a codebook executed by a computing device according to an example of the present disclosure. Herein, the kernel may be executed by the processor of the computing device according (described below in FIG. 10) to an example of the present disclosure.

Referring to FIG. 4, the processor may perform a pre-operation in step S21 using a codebook and an input activation vector to generate a partial sum book, and may load the partial sum book into a cache in step S22. Herein, since the partial sum book includes partial sums corresponding to the results of operations between the input activation vector and the centroid vector for each code in the codebook, when each code in the code matrix is input, the partial sum corresponding to the code may be retrieved in step S23. The partial sums may be added to finally generate an output vector. That is, when the partial sum book is generated by performing the pre-operation in step S21 using the codebook and the input activation vector, the output vector may subsequently be generated by referring to the partial sum book and reading and adding corresponding partial sums.

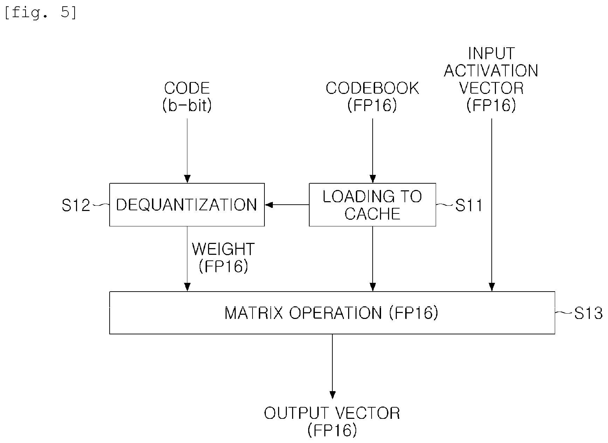

In the related art, as shown in FIG. 5, a codebook is loaded into a cache in step S11, and then dequantization of a code matrix is performed by referring to the codebook step S12. Afterward, when an input activation vector is input, a matrix operation between the input activation vector and the dequantized weight matrix is performed in step S13, and an output vector is generated accordingly.

When FIGS. 4 and 5 are compared, in the case of FIG. 4, rather than the entire codebook, the partial sum book may be loaded into the cache. Centroid vectors for respective codes may be stored in the codebook, and scalar values corresponding to partial sums for respective codes may be stored in the partial sum book. That is, the amount of data included in the partial sum book is significantly reduced compared to the codebook, so memory overhead may be prevented.

In addition, in FIG. 4, instead of dequantizing a code matrix to reconstruct a weight matrix and performing an operation between the weight matrix and an input activation vector, the pre-operation may be performed in step S21 in advance between the input activation vector and the centroid vectors in the codebook, and partial sums corresponding to respective codes may be read from the partial sum book. That is, only a single operation for generating the partial sum book may be performed, and subsequent processing may be carried out by reading the partial sum book. Accordingly, redundant operations that occur during operations between the weight matrix and the input activation vector may be avoided, thereby reducing the amount of unnecessary operation.

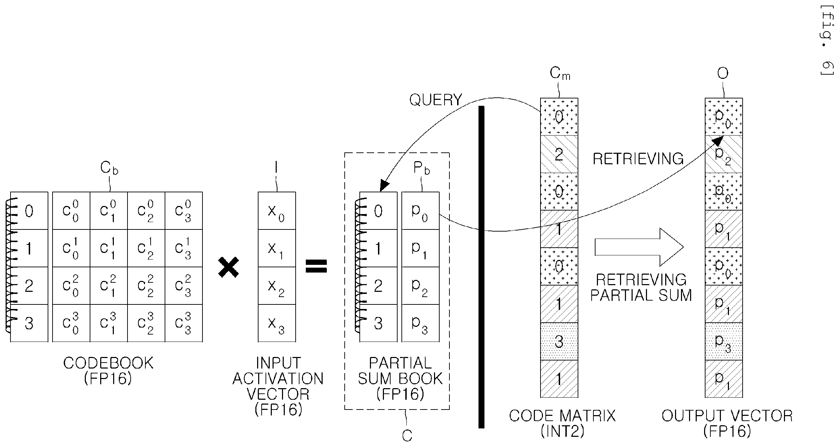

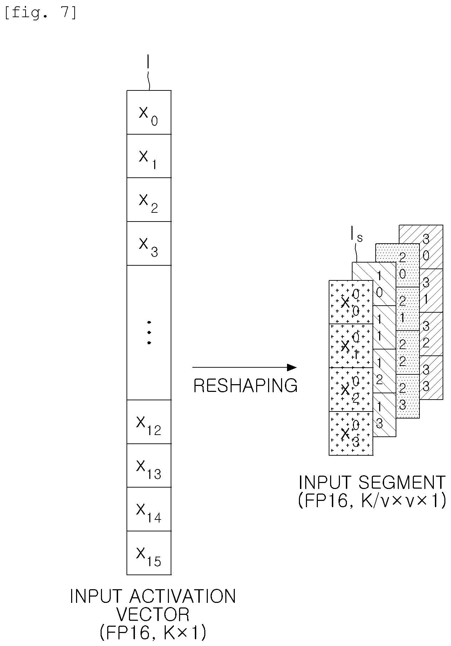

Referring to FIG. 6, the computing device according to an example of the present disclosuremay perform the pre-operation between the codebook (Cb) and the input activation vector (I) to pre-generate the partial sum book (Pb) including the partial sums corresponding to the respective codes. The partial sum book (Pb) may be loaded into the cache (C), and the partial sum book (Pb) may be queried with each code included in the code matrix to retrieve a corresponding partial sum, thereby generating the output vector (O). Specifically, the operation of the matrix operation kernel of the quantization model based on a codebook according to an example of the present disclosure will be described with reference to FIGS. 7 to 9.

Referring to FIG. 7, the processor may reshape the input activation vector (I) to generate input segments (Is). The input activation vector (I) may be generated corresponding to the weight vector (Wm). In this case, a direct operation between the input activation vector(I) and the codebook (Cb) may be impossible. Accordingly, in order to perform the pre-operation between the input activation vector (I) and the codebook (Cb), it is necessary to reshape the input activation vector (I) to match the size of the codebook (Cb).

To this end, the processor may divide the input activation vector according to the vector length (v) by which the codebook (Cb) is divided. That is, the input activation vector may be divided to correspond to the length of centroid vectors stored in the codebook (Cb), thereby generating the input segments (Is). Herein, the length of centroid vectors may correspond to the number of weights included in the centroid vectors that are quantized into the codes when the code matrix (Cm) is generated from the weight matrix (Wm) of the original model.

Herein, as shown in FIG. 7, when the size of the weight matrix (Wm) is M×K and the size of the input activation vector (I) is K×1, K/v input segments (Is) each having the size of v×1 may be generated. In addition, when the size of the weight matrix (Wm) is M×K and the size of the input activation vector (I) is K×1, each input value included in the input segments (Is) may be expressed by x^{j}ₙ = x_{v×j+n}. Herein, v×j+n < K may be satisfied.

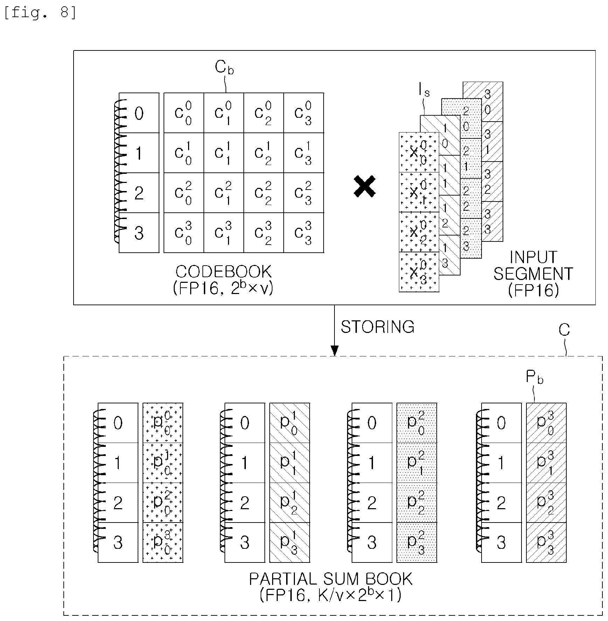

As shown in FIG. 8, the processor may perform the matrix operation between the codebook (Cb) of the quantization model and the input segments (Is) to generate the partial sum book (Pb) including the partial sums corresponding to the respective codes (0, 1, 2, 3) within the codebook (Cb).

Herein, a plurality of input segments (Is) may be generated, and the partial sum books (Pb) for the respective input segments (Is) may be generated. In FIG. 8, it can be seen that there are four input segments (Is), so four partial sum books corresponding to the respective input segments (Is) are generated. In some examples, a plurality of codebooks may be generated for a quantization model, and in this case, a partial sum book may be generated for each of the codebooks.

When performing the matrix operation between the codebook (Cb) and the input segments (Is), the processor may generate the partial sums by performing an inner product between the centroid vector for each code stored in the codebook (Cb) and the input segments (Is). Herein, each of the partial sums may be obtained using Equation 1. ${p}_{i}^{j} = {\sum }_{n = 0}^{v - 1} {c}_{n}^{i} \times {x}_{n}^{j}$

Herein, c denotes a weight, i denotes a code index, n denotes a position (dimension) within a centroid vector, so cⁱₙ corresponds to the weight at the n-th position of code index i. x denotes an input value, j denotes an input segment index, n denotes a position within the input segment, so x^{j}ₙ corresponds to the input value at the n-th position of input segment index j. p denotes a partial sum, i denotes a code index, j denotes an input segment index, so p^{j}ᵢ corresponds to the partial sum between code index i and input segment j.

Accordingly, as shown in FIG. 8, partial sums may be generated through matrix multiplication between the codebook (Cb) and the respective input segments (Is), and the partial sum books (Pb) including the partial sums may be generated.

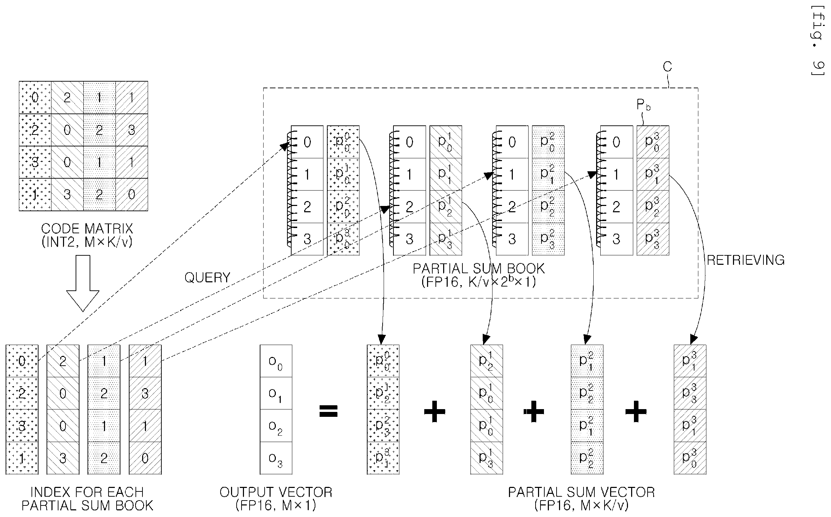

As shown in FIG. 9, the processor may refer to the partial sum books (Pb) to retrieve the partial sums corresponding to the respective codes included in the code matrix (Cm) of the quantization model. In addition, the processor may use the retrieved partial sums to generate the output vector (O) corresponding to the input activation vector (I).

Specifically, the processor may first load the partial sum books (Pb) into the cache (C), and may query the partial sum books (Pb) with the respective codes in the code matrix (Cm), and may retrieve the partial sums corresponding to the codes from the partial sum books (Pb).

Herein, the processor may refer to the partial sum book (Pb) generated corresponding to each column in the code matrix (Cm), and may generate the partial sum vectors corresponding to the column. That is, since one input activation vector (I) is divided into the plurality of input segments (Is), the partial sum books (Pb) may correspond to the respective columns in the code matrix (Cm), considering operations with the respective input segments (Is) before division. Accordingly, as shown in FIG. 9, the code matrix (Cm) may be indexed to the corresponding partial sum books (Pb), and the partial sum vectors may be generated by referring to the respective partial sum books (Pb). Herein, the partial sum vectors may be added to generate the output vector.

FIG. 10 is a block diagram illustrating a computing environment suitable for use in examples of the present disclosure. In the shown example, each of the components may have different functions and capabilities other than those described below, and additional components may be included other than those described below.

The shown computing environment 10 includes a computing device 12. In an example, the computing device 12 may include at least one processor 14, a computer-readable storage medium 16, and a communication bus 18.

The processor 14 may cause the computing device 12 to operate according to the above-mentioned examples. For example, the processor 14 may execute various types of kernels, and may execute one or more programs stored in the computer-readable storage medium 16. The one or more programs may include one or more computer-executable instructions. When executed by the processor 14, the computer-executable instructions may be configured to cause the computing device 12 to perform operations according to the examples.

In some examples, the processor 14 may process various types of artificial intelligence (AI) operations, and the processor 14 may process various layers of the generative language model through the kernel. For example, the processor may process matrix multiplication, max pooling, depthwise convolution, data layout transformation, normalization, activation, and nonlinear function operations.

Herein, the processor 14 may include a central processing unit (CPU), a graphics processing unit (GPU), a neural processing unit (NPU), a tensor processing unit (TPU), a field-programmable gate array (FPGA), an application-specific integrated circuit (ASIC), and a data processing unit (DPU).

The computer-readable storage medium 16 is configured to store computer-executable instructions or program code, program data, and/or other suitable forms of information. The program 20 stored in the computer-readable storage medium 16 may include a set of instructions executable by the processor 14. In an example, the computer-readable storage medium 16 may be a memory (volatile memory such as random-access memory, non-volatile memory, or any suitable combination thereof), one or more magnetic disk storage devices, optical disk storage devices, flash memory devices, any other form of storage medium accessible by the computing device 12 and capable of storing desired information, or any suitable combination thereof.

The communication bus 18 interconnects other various components of the computing device 12 including the processor 14 and the computer-readable storage medium 16.

The computing device 12 may also include one or more input/output interfaces 22 that provide interfaces for one or more input/output devices 24, and one or more network communication interfaces 26. The input/output interface 22 and the network communication interface 26 are connected to the communication bus 18. The input/output device 24 may be connected to other components of the computing device 12 through the input/output interface 22. Examples of the input/output device 24 may include input devices, such as pointing devices (a mouse or a trackpad), a keyboard, a touch input device (a touch pad or a touch screen), a voice or sound input device, various types of sensor devices and/or photographing devices; and/or output devices, such as a display device, a printer, a speaker, and/or a network card. An exemplary input/output device 24 may be included inside the computing device 12 as a component of the computing device 12, or may be connected to the computing device 12 as a separate device distinct from the computing device 12.

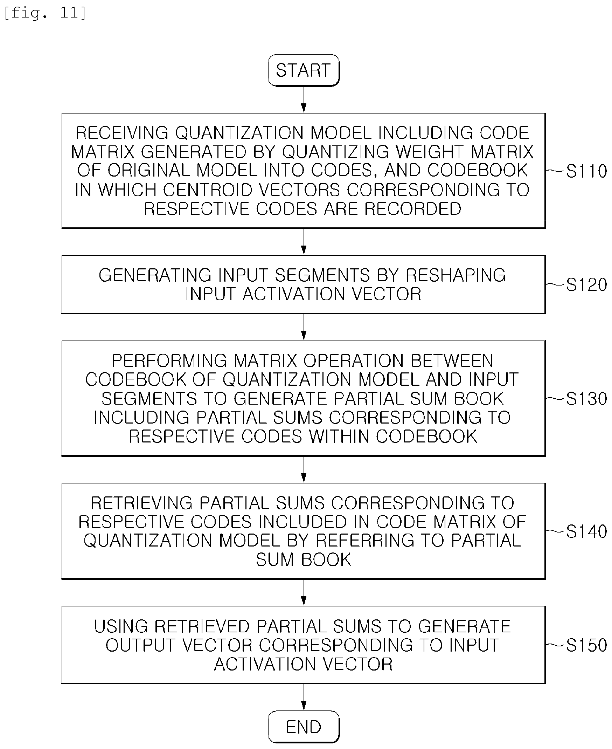

FIG. 11 is a flowchart illustrating a method for accelerating general matrix multiply for a quantization model based on a codebook according to an example of the present disclosure. Herein, each of the steps in FIG. 11 may be performed by the computing device 12 according to an example of the present disclosure.

Referring to FIG. 11, the computing device 12 may receive the quantization model including the code matrix generated by quantizing a weight matrix of an original model into codes, and the codebook in which centroid vectors corresponding to the respective codes are recorded in step S110.

Herein, the code matrix may be generated by clustering vectors having a set size by which the weight matrix is divided, and generating the centroid vectors corresponding to centroids of respective clusters, and converting the weight matrix into the codes allocated to the centroid vectors.

The computing device 12 may generate at least one input segment by reshaping an input activation vector in step S120. That is, the input activation vector may be generated corresponding to the weight vector. In this case, a direct operation between the input activation vector and the codebook may be impossible. Accordingly, the computing device 12 may reshape the input activation vector according to the size of the codebook. To this end, the input activation vector may be divided to correspond to the length of centroid vectors stored in the codebook, thereby generating the input segments. Herein, the length of the centroid vectors may correspond to the number of weights included in the centroid vectors that is quantized into the codes when the code matrix is generated from the weight matrix of the original model.

The computing device 12 may perform the matrix operation between the codebook of the quantization model and the input segments to generate the partial sum book including the partial sums corresponding to the respective codes within the codebook in step S130. Herein, a plurality of input segments may be generated, and the partial sum books for the respective input segments may be generated. In some examples, a plurality of codebooks may be generated for a quantization model, and in this case, a partial sum book may be generated for each of the codebooks.

Specifically, the computing device 12 may generate the partial sums by performing an inner product between centroid vectors for the respective codes stored in the codebook and the input segments. Herein, the partial sums corresponding to the codes may be generated for each of the input segments, and the respective partial sum books may be generated.

The computing device 12 may retrieve, by referring to the partial sum book, the partial sums corresponding to the respective codes included in the code matrix of the quantization model in step S140. Specifically, the computing device 12 may first load the partial sum book into the cache, and may query the partial sum book with the respective codes in the code matrix, and may retrieve the partial sums corresponding to the codes from the partial sum book.

Herein, the computing device 12 may refer to the partial sum book generated corresponding to each column in the code matrix, and may generate the partial sum vectors corresponding to the column. That is, since one input activation vector is divided into a plurality of input segments, the partial sum books may correspond to the respective columns in the code matrix, considering operations with the respective input segments before division. Accordingly, by referring to the partial sum book (Pb) corresponding to each column of the code matrix, the partial sum vectors corresponding to the column may be generated.

The computing device 12 may use the retrieved partial sums to generate the output vector corresponding to the input activation vector in step S150. In some examples, the partial sum vectors may be added to generate the output vector.

The present invention described above may be implemented as computer-readable code on a computer-readable recording medium on which a program is recorded. A computer-readable recording medium may continuously store computer-executable programs, or may temporarily store the same for execution or downloading. In addition, the computer-readable recording medium may be various recording device or storage device in the form of a single hardware element or a combination of several hardware elements. The computer-readable recording medium is not limited to a medium directly connected to any computer system, and may be distributed over a network. Examples of a non-transitory computer-readable medium include magnetic media, such as hard disks, floppy disks, and magnetic tapes; optical recording media, such as CD-ROMs and DVDs; magneto-optical media, such as floptical disks; and ROM, RAM, and flash memory, which are configured to store program instructions. In addition, other examples of the medium may include recording media or storage media managed by app stores that distribute applications, by sites that provide or distribute other various software elements, or by servers. Accordingly, the above detailed description should not be construed as restrictive in all respects but should be considered illustrative. The scope of the present invention should be determined by a reasonable interpretation of the appended claims.

The present invention is not limited to the above-described examples and the accompanying drawings. It will be apparent to those skilled in the art that elements according to the present invention may be substituted, modified, and changed within the scope of the present invention.

## Claims

1. A method for accelerating general matrix multiply, GEMM, for a quantization model based on a codebook, the method being performed by a processor and comprising:
generating (S120) at least one input segment by reshaping an input activation vector;
generating (S130) a partial sum book, Psum book, including partial sums corresponding to respective codes in the codebook of the quantization model by performing a matrix operation between the codebook and the at least one input segment;
retrieving (S140) the partial sums corresponding to the respective codes included in a code matrix of the quantization model by referring to the partial sum book; and
generating (S150) an output vector corresponding to the input activation vector by using the retrieved partial sums.

2. The method of claim 1, wherein in the generating of the at least one input segment, the at least one input segment is generated by dividing the input activation vector to correspond to a length of centroid vectors stored in the codebook corresponding to the codes.

3. The method of claim 2, wherein the length of the centroid vectors corresponds to the number of weights included in the centroid vectors quantized into the codes when the code matrix is generated from a weight matrix of an original model.

4. The method of any one of claims 1 to 3, wherein in the generating of the partial sum book, the partial sums are generated by performing an inner product between centroid vectors for the respective codes stored in the codebook and the at least one input segment.

5. The method of any one of claims 1 to 4, wherein in the generating of the partial sum book, when there is a plurality of the codebooks or the input segments, a plurality of the partial sum books are generated for the codebooks or the input segments, respectively.

6. The method of any one of claims 1 to 5, wherein in the retrieving of the partial sums, the partial sum book is loaded into a cache, the partial sum book is queried with each of the codes in the code matrix, and the partial sums corresponding to the respective codes are retrieved from the partial sum book.

7. The method of any one of claims 1 to 6, wherein in the retrieving of the partial sums, by referring to the partial sum book generated corresponding to each column in the code matrix, generating partial sum vectors corresponding to the respective columns.

8. The method of claim 7, wherein in the generating of the output vector, the partial sum vectors are added to generate the output vector.

9. The method of any one of claims 1 to 8, further comprising
receiving the quantization model including the code matrix generated by quantizing a weight matrix of an original model into the codes, and the codebook in which centroid vectors corresponding to the respective codes are recorded,
wherein the code matrix is generated by clustering vectors having a set size by which the weight matrix is divided, and generating the centroid vectors corresponding to centroids of respective clusters, and converting the weight matrix into the codes allocated to the centroid vectors.

10. A non-transitory computer-readable recording media (16) storing a computer program that, when executed by a processor, performs a method for accelerating general matrix multiply, GEMM, for a quantization model based on a codebook according to claim 1.

11. A computing device (12) for accelerating general matrix multiply, GEMM, for a quantization model based on a codebook, the computing device comprising:
a processor (14),
wherein the processor (14) is configured to:
generate (S120) at least one input segment by reshaping an input activation vector;
generate (S130) a partial sum book, Psum book, including partial sums corresponding to respective codes in the codebook of the quantization model by performing a matrix operation between the codebook and the at least one input segment;
retrieve (S140) the partial sums corresponding to the respective codes included in a code matrix of the quantization model by referring to the partial sum book; and
generate (S150) an output vector corresponding to the input activation vector by using the retrieved partial sums.
